(19) **Europäisches Patentamt / European Patent Office / Office européen des brevets**

(11) **EP 3 540 928 B1**

(12) **EUROPEAN PATENT SPECIFICATION**

(45) Date of publication and mention
of the grant of the patent:
**09.02.2022 Bulletin 2022/06**

(21) Application number: **18161349.8**

(22) Date of filing: **13.03.2018**

(51) International Patent Classification (IPC):
*H02M 7/00* *(2006.01)*   *H02M 1/12* *(2006.01)*
*B67D 3/00* *(2006.01)*   *H01L 23/473* *(2006.01)*
*H01L 25/11* *(2006.01)*   *H02H 1/00* *(2006.01)*
*H05K 7/20* *(2006.01)*

(52) Cooperative Patent Classification (CPC):
**H02M 7/003; H05K 7/20927;** H02M 1/123

(54) **ELECTRICAL APPARATUS**

ELEKTRISCHE VORRICHTUNG

APPAREIL ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.09.2019 Bulletin 2019/38**

(73) Proprietor: **General Electric Technology GmbH
5400 Baden (CH)**

(72) Inventor: **DAVIDSON, Colin Charnock
Stafford, Staffordshire ST16 1WS (GB)**

(74) Representative: **Brevalex
95, rue d'Amsterdam
75378 Paris Cedex 8 (FR)**

(56) References cited:
WO-A1-2017/007229   GB-A- 2 544 820
JP-A- S5 788 751   US-A1- 2010 020 452
US-A1- 2018 010 833

**Description**

This invention relates to an electrical apparatus, preferably a switching valve assembly for use in high voltage direct current (HVDC) applications.

It is known to use cooling equipment to control the temperature of electrical hardware so as to improve their efficiency and reliability.

For example, a water-cooled thyristor valve assembly with a leakage current monitor is described in JPS5788751. Furthermore, leakage current harvesting is proposed in GB2544820 and US2010020452.

The invention is defined by the features of claim 1. The dependent claims recite advanteageous embodiments of the invention.

According to an aspect of the invention, as set forth in claim1, there is provided a thyristor valve assembly comprising a corona shield and a coolant carrier for carrying coolant, the corona shield being connected to the thyristor valve assembly via a busbar, the coolant carrier being arranged to interconnect a plurality of positions in the thyristor valve assembly and the thyristor valve assembly being operable so as to configure the plurality of positions to be at different electrical potentials, wherein the thyristor valve assembly further includes a power supply circuit connected between a coolant carrier section and the corona shield such that, in use, the power supply circuit is configured to draw a leakage current from the coolant carrier so as to harvest the leakage current and to provide a power supply source for powering one or more electrical devices.

It will be understood that, for the purposes of this specification, the coolant carrier may be in the form of any medium or device designed to carry coolant. For example, the coolant carrier may include one or more fluid conduits, such as pipes.

The primary purpose of the coolant carrier is to circulate coolant throughout the electrical apparatus so as to allow the coolant to absorb heat generated by the electrical apparatus, which has the effect of lowering the temperature of the electrical apparatus and thereby advantageously improving the performance of the electrical apparatus.

Typically, in coolant equipment, an ideal coolant would have zero electrical conductivity. However, in the case of the invention, a practical coolant would have a minimum level of electrical conductivity in order for the invention to work. Practical implementations of the electrical apparatus of the invention may include, but is not limited to, the use of a coolant which is or includes de-ionised water, or the like, in which the achievable minimum level of electrical conductivity is relatively high in comparison to, for example, oil coolant, air coolant, or the like. Thus, the electrical apparatus of the invention exploits the non-ideal electrical conductivity of the practical coolant.

As a result of the use of a coolant with a sufficiently high non-zero electrical conductivity and the presence of the different electrical potentials of the plurality of positions, a leakage current flows in the coolant carrier interconnecting the plurality of positions in the electrical apparatus. The inclusion of the power supply circuit in the electrical apparatus enables power to be harvested from the leakage current for supply to one or more electrical devices. Such electrical devices may include, but are not limited to, sensors and instrumentation for measuring and monitoring operating parameters of the electrical apparatus. Such sensors and instrumentation could be configured to, for example, monitor and measure voltage, current or temperature of the electrical apparatus, or detect leakage or spillage of coolant from the coolant carrier. The inclusion of the power supply circuit in the electrical apparatus therefore obviates the need to provide an additional power source which would not only increase operating costs but also take up extra space.

It will be appreciated that the electrical apparatus of the invention works with any coolant with a non-zero electrical conductivity which is sufficiently high, so that the use of the coolant in the coolant carrier in combination with the presence of the different electrical potentials of the plurality of positions results in a flow of the leakage current in the coolant carrier interconnecting the plurality of positions in the electrical apparatus.

In embodiments of the invention in which the electrical apparatus includes a plurality of electrical components, each of the plurality of positions in the electrical apparatus may correspond to a respective one of the plurality of electrical components. The invention is useful for an electrical apparatus with a plurality of electrical components, each of which is operating at a respective different electrical potential.

In such embodiments, the electrical apparatus may include a plurality of additional electrical components, and the coolant carrier may be disconnected from the plurality of additional electrical components. It will be appreciated that the invention is applicable to configurations of the electrical apparatus in which the coolant carrier covers all of its electrical components, and in which the coolant carrier covers only some of the electrical components.

The invention is applicable to a wide range of electrical apparatus. For example, the electrical apparatus may include a switching valve. Optionally the switching valve may include a plurality of switching modules, each of the plurality of positions corresponding to a respective one of the plurality of switching modules such that the coolant carrier is arranged to interconnect the plurality of switching modules.

The flow of leakage current in the coolant carrier results in the coolant carrier acting as a grading resistor, or a plurality of grading resistors, with a resistance value which may be comparable relative to the resistance of the electrical apparatus itself so as to affect the operation of the electrical apparatus.

In a preferred embodiment of the invention, the coolant carrier may be arranged to interconnect the plurality of positions such that, in use of the electrical apparatus, the coolant carrier forms an electrically balanced circuit. The formation of the electrically balanced circuit eliminates or minimises the influence of the resistance of the coolant carrier on the operation of the electrical apparatus.

The formation of the electrically balanced circuit may be achieved through the inclusion of an electrically conductive member in the electrical apparatus. When the electrical apparatus includes an electrically conductive member, the coolant carrier may be arranged to interconnect the plurality of positions and the electrically conductive member such that, in use of the electrical apparatus, the coolant carrier forms an electrically balanced circuit.

In further embodiments of the invention, the electrically conductive member may be or may include the electric field shielding member. Although the electric field shielding member typically does not include any active components which requires cooling, the connection of the coolant carrier to the electric field shielding member provides a convenient way of forming the electrically balanced circuit without requiring additional hardware.

The electric field shielding member may be arranged in any position about the electrical apparatus, but preferably the electric field shielding member is arranged at one end of the electrical apparatus. For example, when the electrical apparatus includes the plurality of switching modules, the electric field shielding member may be arranged at one end of the plurality of switching modules.

Since the electric field shielding member is usually at a high electrical potential, it can be challenging to provide power to any electrical device in the vicinity of the electric field shielding member. The inclusion of the power supply circuit in the electrical apparatus however provides a reliable means for supplying the desired power to one or more electrical devices in the vicinity of the electric field shielding member.

The electrically balanced circuit may be formed by the coolant carrier including first and second coolant carrier portions. Each of the first and second coolant carrier portions may be arranged to interconnect the plurality of positions, the first and second coolant carrier portions being in fluid communication with each other.

In still further embodiments of the invention, the electrical apparatus may further include a collector arranged to collect leaked or spilt coolant from the coolant carrier, and the electrical apparatus may further include a monitoring device configured to monitor a level of collected coolant in the collector, wherein the collector may include an outlet for permitting discharge of the collected coolant from the collector.

Optionally the monitoring device may include an optical source configured to direct light towards a surface of the collected coolant in the collector, and the monitoring device may further include an optical sensor configured to detect light reflected off the surface of the collected coolant in the collector.

Further optionally the outlet may be in the form of a weir, or the outlet may be in the form of a hole in a base of the collector.

Such configurations of the electrical apparatus provide a reliable and easy to manufacture means for monitoring the rate at which coolant is leaked or spilled from the coolant carrier, particularly due to the lack of moving parts.

It will be appreciated that the use of the terms "first" and "second", and the like, in this patent specification is merely intended to help distinguish between similar features (e.g. the first and second coolant carrier portions), and is not intended to indicate the relative importance of one feature over another feature, unless otherwise specified.

A preferred embodiment of the invention will now be described, by way of a non-limiting example, with reference to the accompanying drawings in which:

Figure 1 shows schematically a thyristor valve assembly according to an embodiment of the invention;

Figure 2 shows an equivalent electrical circuit representative of the thyristor valve assembly of Figure 1;

Figure 3 illustrates voltage profiles of thyristor switching modules of the thyristor valve assembly of Figure 1;

Figure 4 shows schematically a power supply circuit of the thyristor valve assembly of Figure 1;

Figure 5 shows schematically a mechanism for detecting a leakage of coolant from coolant circuits of the thyristor valve assembly of Figure 1;

Figures 6 and 7 respectively show schematically alternative mechanisms for detecting a leakage of coolant from coolant circuits of the thyristor valve assembly of Figure 1; and

Figure 8 shows schematically an exemplary collector for use in the mechanisms of Figures 5 to 7.

The figures are not necessarily to scale, and certain features and certain views of the figures may be shown exaggerated in scale or in schematic form in the interests of clarity and conciseness.

The following embodiment of the invention is used primarily in HVDC applications, but it will be appreciated that the following embodiment of the invention is applicable mutatis mutandis to other applications operating at different voltage levels.

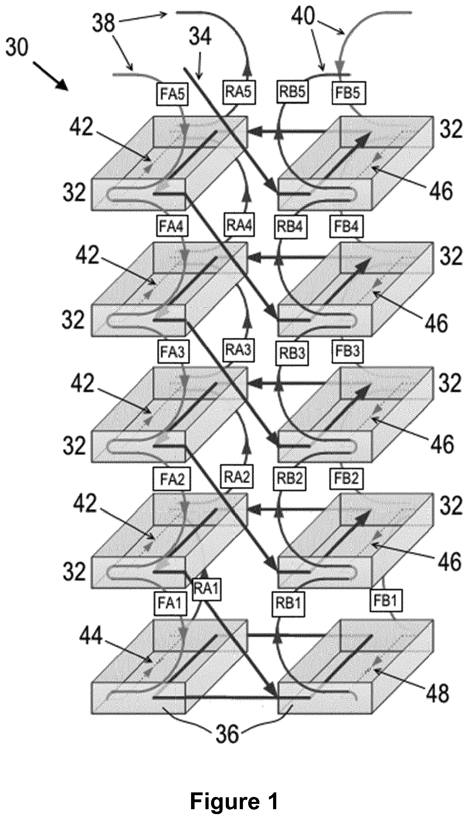

A thyristor valve assembly according to an embodiment of the invention is shown in Figure 1, and is designated generally by the reference numeral 30. The thyristor valve assembly 30 is in the form of a Multiple Valve Unit for a converter, such as a Line-Commutated Converter (LCC). In use, the thyristor valve assembly 30 is usually suspended from a ceiling of a valve hall (not shown), with the top of the thyristor valve assembly 30 defining a first DC terminal and the bottom of the thyristor valve assembly 30 defining a second DC terminal. Typically, the bottom of the thyristor valve assembly 30 experiences the highest electrical potential with respect to ground so that suspension insulators, for suspending the thyristor valve assembly 30 from the ceiling, experience a more modest voltage stress.

The thyristor valve assembly 30 includes a thyristor switching valve. The thyristor switching valve includes a plurality of thyristor switching modules 32, which in the embodiment shown are stacked vertically to form two valve stacks of the thyristor switching modules 32. The thyristor switching modules 32 of the valve stacks are combined to form a single series connection 34 of thyristor switching modules 32. In use, when a given thyristor switching module 32 is in an off-state, an off-state voltage appears across the thyristor switching module 32.

A corona shield 36 is located at the bottom of the thyristor valve assembly 30, and is connected to the bottom of the thyristor valve assembly 30 via a busbar 50. The function of the corona shield 36 is to present a smooth external electric field profile and thereby prevent electrical corona discharge from occurring under normal conditions. It will be appreciated that one or more additional corona shields may be arranged at other positions about the thyristor valve assembly 30.

A cooling system, including first and second coolant circuits 38,40, is arranged to feed liquid coolant into the valve stacks from the top of the thyristor valve assembly 30 where the electrical insulation requirements are more modest. Each coolant circuit 38,40 may include, for example, a number of separate pipes connected to manifold assemblies in the thyristor switching modules 32.

The first coolant circuit 38 is arranged to direct liquid coolant through each of the thyristor switching modules 32 in a first of the valve stacks. More specifically, in the first valve stack, the first coolant circuit 38 is arranged to extend downwardly through the uppermost thyristor switching module 32, the intermediate thyristor switching modules 32 and the lowermost thyristor switching module 32 in succession, before passing through a first side of the corona shield 36, and looping back to extend upwardly through the lowermost thyristor switching module 32, the intermediate thyristor switching modules 32 and the uppermost thyristor switching module 32 in succession.

Each thyristor switching module 32 of the first valve stack includes a respective coolant conduit 42 interconnecting the downwardly and upwardly extending coolant circuit sections of the first coolant circuit 38, which allows the liquid coolant to be tapped off at each thyristor switching module 32 to cool the electrical components contained therein. The first side of the corona shield 36 also includes a bypass coolant conduit 44 interconnecting the downwardly and upwardly extending coolant circuit sections of the first coolant circuit 38 to prevent the liquid coolant in the first coolant circuit 38 from being stagnant.

Similarly, the second coolant circuit 40 is arranged to direct liquid coolant through each of the thyristor switching modules 32 in a second of the valve stacks. More specifically, in the second valve stack, the second coolant circuit 40 is arranged to extend downwardly through the uppermost thyristor switching module 32, the intermediate thyristor switching modules 32 and the lowermost thyristor switching module 32 in succession, before passing through a second side of the corona shield 36, and then looping back to extend upwardly through the lowermost thyristor switching module 32, the intermediate thyristor switching modules 32 and the uppermost thyristor switching module 32 in succession.

Each thyristor switching module 32 of the second valve stack includes a respective coolant conduit 46 interconnecting the downwardly and upwardly extending coolant circuit sections of the second coolant circuit 40, which allows the liquid coolant to be tapped off at each thyristor switching module 32 to cool the electrical components contained therein. The second side of the corona shield 36 also includes a bypass coolant conduit 48 interconnecting the downwardly and upwardly extending coolant circuit sections of the second coolant circuit 40 to prevent the liquid coolant in the second coolant circuit 40 from being stagnant.

When the liquid coolant is highly purified de-ionised water (sometimes with anti-freeze added), there is always a minimum level of electrical conductivity governed by the extent to which water molecules ($H_2O$) dissociate into hydrogen and hydroxyl ions (H+ and OH-). As a result, coolant circuit sections of the coolant circuits 38,40 interconnecting different thyristor switching modules 32 act as grading resistors with finite resistances, typically measured in tens or hundreds of M$\Omega$, which are comparable relative to the off-state resistances of the thyristor switching modules 32. It is therefore desirable for the coolant circuits 38,40 to form an electrically balanced circuit so that they do not result in voltage unbalance among the thyristor switching modules 32, which would adversely affect the operation of the thyristor valve assembly 30.

The problem of voltage unbalance can be avoided through the interconnection of the coolant circuits 38,40 and the corona shield 36 which enables the coolant circuits 38,40 to form an electrically balanced circuit.

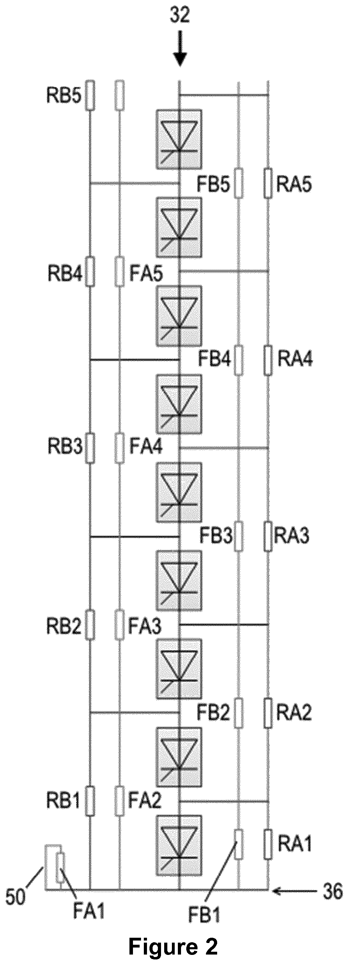

Figure 2 shows an equivalent electrical circuit representative of the thyristor valve assembly 30. The thyristor switching modules 32, the corona shield 36, and the coolant circuits 38,40 are represented in the equivalent electrical circuit.

For ease of description, each coolant circuit section of each coolant circuit 38,40 is labelled as FAx or RBx, where 'F' refers to a downwardly extending coolant circuit section, 'R' refers to an upwardly extending coolant circuit section, 'A' refers to a coolant circuit section of the first coolant circuit 38, 'B' refers to a coolant circuit section of the second coolant circuit 40, and 'x' indicates the vertical position of the coolant circuit section with the lowermost coolant circuit section being labelled as '1', the intermediate coolant circuit sections being labelled as '2', '3' and '4', and the uppermost coolant circuit section being labelled as '5'.

The downwardly and upwardly extending coolant circuit sections of the first coolant circuit 38 interconnecting the lowermost thyristor switching module 32 of the first valve stack and the first side of the corona shield 36 are respectively labelled as FA1 and RA1, and the downwardly and upwardly extending coolant circuit sections of the second coolant circuit 40 interconnecting the lowermost thyristor switching module 32 of the second valve stack and the second side of the corona shield 36 are respectively labelled as FB1 and RB1.

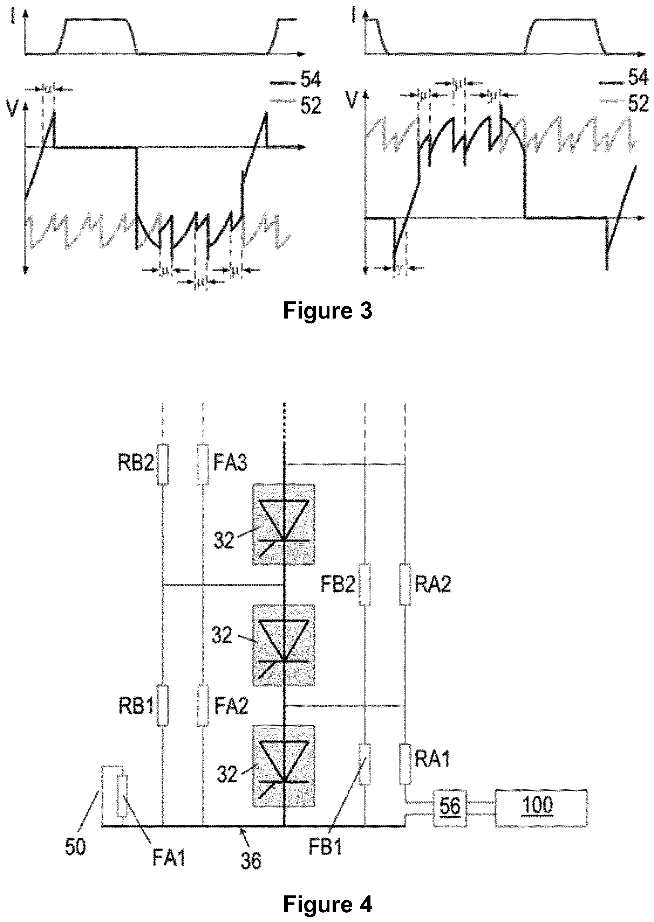

The first coolant circuit section FA1 experiences no voltage because it is shunted by the busbar 50 connecting the corona shield 36 to the bottom of the thyristor valve assembly 30. The first coolant circuit section RA1 and the second coolant circuit section FB1 each experiences a voltage corresponding to the off-state voltage across a single thyristor switching module 32, which in the embodiment shown is the lowermost thyristor module in the first valve stack. In order to form an electrically balanced circuit, the first coolant circuit section RA1 and the second coolant circuit section FB1 are designed to have half the length of each of the other coolant circuit sections which experience a voltage corresponding to the off-state voltage across two thyristor switching modules 32. Figure 3 illustrates profiles of the voltage across two thyristor switching modules 32 during the operation of the thyristor switching valve when the associated converter is in rectifier mode and inverter mode. The voltage consists of a DC offset 52 and an AC component 54 comprising sinusoidal voltage sections.

As a result of the voltage experienced by each coolant circuit section and the electrical conductivity of the coolant, a leakage current flows through each coolant circuit 38,40. For example, in an exemplary configuration of the thyristor valve assembly 30, the peak voltage across a coolant circuit section corresponding to the off-state voltage across two thyristor switching modules 32 may be approximately 100 kV with a DC component of approximately 20 kV, and the resistance of the coolant circuit section may be in the range of 10 to 100 MΩ depending on the electrical conductivity of the coolant, which results in a leakage current of 1 to 10 mA flowing in the corresponding coolant circuit 38,40.

The thyristor valve assembly 30 further includes a power supply circuit 56. In the embodiment as shown in Figure 4, the power supply circuit 56 includes a converter which is connected in series with the downwardly extending, lowermost coolant circuit section of the first coolant circuit 38 between the lowermost thyristor switching module 32 of the first valve stack and the first side of the corona shield 36. This may be achieved by, for example, opening a wire link provided for bonding the downwardly extending, lowermost coolant circuit section of the first coolant circuit 38 with the first side of the corona shield 36, and then connecting the converter between the downwardly extending, lowermost coolant circuit section of the first coolant circuit 38 and the first side of the corona shield 36. Alternatively, in other embodiments of the invention, the converter may be connected in series with the upwardly extending, lowermost coolant circuit section of the second coolant circuit 40 between the lowermost thyristor switching module 32 of the second valve stack and the second side of the corona shield 36.

Such connection of the power supply circuit 56 permits the leakage current to be drawn from the coolant circuits 38,40 so as to provide a power supply source for powering one or more electrical devices 100, such as sensors and instrumentation for measuring and monitoring operating parameters of the thyristor valve assembly 30. Under such circumstances, the coolant circuits 38,40 acts as current sources.

The configuration of the thyristor valve assembly 30 of Figure 1 therefore provides a way of harvesting the leakage current flowing in the cooling system for use as a power supply source for powering one or more electrical devices. This is particularly useful for powering electrical devices located in the vicinity of the corona shield 36 which is at a high electrical potential with respect to ground.

It will be appreciated that the configuration of the embodiment shown is merely chosen to help illustrate the working of the invention, and may be replaced by another thyristor valve assembly configuration, examples of which are set out as follows.

The thyristor valve assembly 30 may include a single valve stack of the thyristor switching modules 32.

The coolant circuits 38,40 may be arranged in different ways to extend through the thyristor switching modules 32 and the corona shield 36.

The power supply circuit 56 may be configured to be additionally or alternatively connected to one or more other coolant circuit sections in order to harvest the leakage current from the cooling system for power supply purposes.

The thyristor valve assembly 30 may include a plurality of power supply circuits, each of which is connected to a different coolant circuit section. For example, power supply circuits may be respectively connected to the coolant circuit sections FB1, RA1, RB1 interconnecting the lowermost thyristor switching modules 32 to the corona shield 36. This provides multiple power supply sources and thus provide redundancy in the supply of power.

In other embodiments of the invention, the thyristor valve assembly may be mounted on a floor of the valve hall. Post insulators may be used to support the base of the thyristor valve assembly, with the cooling system configured to feed liquid coolant from floor level towards the top of the valve stacks and looping back towards the floor level. The corona shield may be located at the top of the thyristor valve assembly. In such embodiments, the invention may be used to harvest the leakage current flowing in the cooling system for use as a power supply source for powering one or more electrical devices in the vicinity of the corona shield at the top of the thyristor valve assembly.

It will be also appreciated that the invention is applicable to other types of electrical apparatus, such as other types of switching valve assemblies.

During the operation of the thyristor valve assembly 30, a fault in the cooling system may result in leakage, or spillage, of coolant from the coolant circuits, which poses a safety hazard.

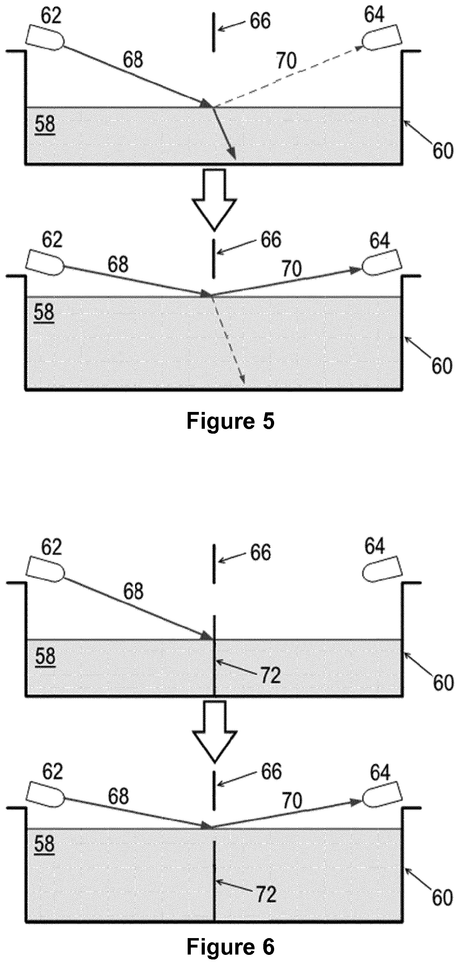

Optionally the thyristor valve assembly 30 may further include a mechanism for detecting the leakage of coolant from the coolant circuits 38,40. Features of the mechanism is described as follows with reference to Figures 5 to 8.

The leaked coolant is collected in a drip tray (not shown) arranged below the coolant circuits 38,40 and near the corona shield 36. The leaked coolant is then channelled into a collector 60, which in the embodiment shown is in the exemplary form of an open-top tray.

A monitoring device includes an optical source and an optical sensor to monitor a level of the collected coolant 58 in the collector 60. The optical source is in the form of an optical transmitter 62 (e.g. an LED) which is positioned above one side of the container. The optical sensor is in the form of an opto-receiver 64 which is positioned above the opposite side of the container. The opto-receiver 64 may include, but is not limited to, a photodiode, phototransistor, or light-dependent resistor. An optical barrier 66 is positioned between the optical transmitter 62 and the opto-receiver 64 to block direct transmission of light between the optical transmitter 62 and the opto-receiver 64. Figure 5 shows the arrangement of the optical transmitter 62, opto-receiver 64 and optical barrier 66.

The optical transmitter 62 is configured to direct light 68 towards the surface of the collected coolant 58 so that the light 70 is reflected off the surface of the collected coolant 58 and towards the opto-receiver 64.

When an incident light 68 reaches a boundary between two materials with different refractive indices (which in the embodiment shown is the interface between the collected coolant 58 and air), part of the incident light 68 is transmitted while the other part of the incident light is reflected. When the incident light 68 originates from air with a low refractive index and reaches the coolant with the higher refractive index, most of the incident light 68 is transmitted when the angle of incidence is close to normal (i.e. perpendicular to the surface), but as the angle of incidence changes, so do the reflection and transmission coefficients. At near-grazing incidence, almost all of the incident light 68 is reflected.

Thus, at low levels of the collected coolant 58, the angle of incidence is low and as a result the reflected light 70 is weak. As the level of the collected coolant 58 rises, the angle of incidence increases, which in turn increases the strength of the reflected light 70. When the level of the collected coolant 58 reaches a predefined level and as a result the strength of the reflected light 70 reaches a predefined threshold, the detection of the reflected light 70 by the opto-receiver 64 results in the generation of an indicator signal for communicating the leakage occurrence to, for example, an operator, control equipment and/or protection equipment. The indicator signal may be in the form of an audible signal (e.g. an alarm), a visual signal (e.g. an indicator light), or a data signal configured to convey information about the leakage occurrence.

It will be appreciated that the monitoring device may be configured to work with a single predefined level of the collected coolant 58 and a single predefined threshold of the reflected light strength, or with multiple predefined levels of the collected coolant 58 and multiple predefined thresholds of the reflected light strength. In the case of the latter, the predefined levels and predefined thresholds may be designed to correspond to a major leak and a minor leak respectively.

Optionally a further optical barrier 72 may be provided inside the collector 60 such that, at low levels of the collected coolant 58 below the predefined level, the further optical barrier 72 is exposed above the level of the collected coolant 58 to either block the incident light 68 from the optical transmitter 62 reaching the surface of the collected coolant 58 or block the reflected light 70 from reaching the opto-receiver 64. Figure 6 shows the arrangement of the further optical barrier. At higher levels of the collected coolant 58 at and above the predefined level, the further optical barrier 72 becomes submerged to permit the reflection of light 70 off the surface of the collected coolant 58. This has the effect of providing greater selectivity between low and high collected coolant levels.

Further optionally the optical transmitter and opto-receiver may be placed above the same side of the collector, and a mirror is placed above the opposite side of the collector so that, when the predefined level of the collected coolant 58 is reached, light is reflected off the surface of the collected coolant 58 towards the mirror which is arranged to reflect the light towards the opto-receiver by, for example, directing the light towards the opto-receiver or by reflecting the light off the surface of the collected coolant 58 towards the opto-receiver.

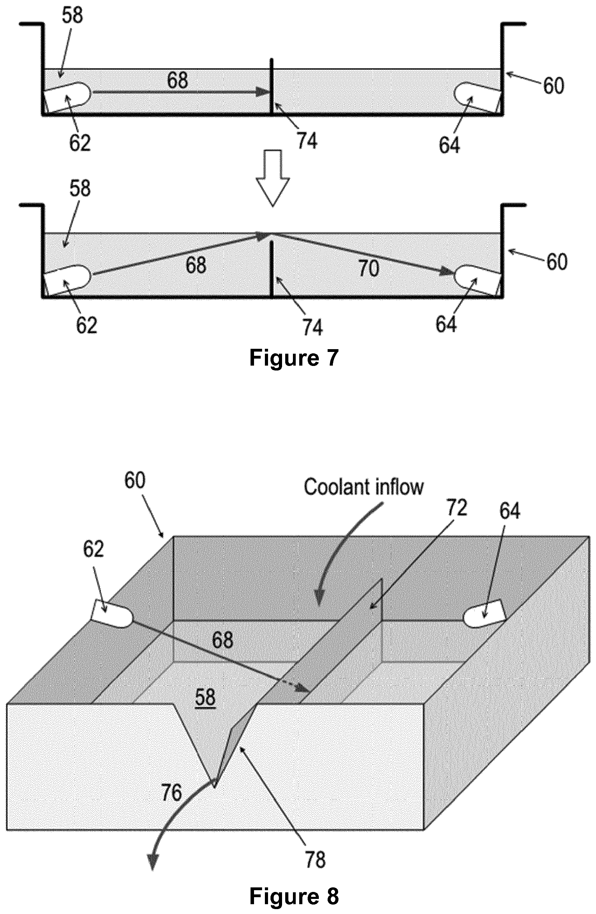

Still further optionally, the optical transmitter 62 and opto-receiver 64 may be placed at the bottom of the collector 60, with an optical barrier 74 arranged therebetween to block direct transmission of light between the optical transmitter 62 and the opto-receiver 64. This arrangement is shown in Figure 7. The optical transmitter 62 and opto-receiver 64 are arranged so that, when the predefined level of the collected coolant 58 is reached, light 70 is reflected off the internal surface of the collected coolant 58, i.e. the interface between the collected coolant 58 and air, towards the opto-receiver 64. Alternatively, the optical transmitter and opto-receiver 64 may be located outside the collector which includes a window to permit transmission of light into and out of the collector.

The output of light from the optical transmitter 62 may be passed through a horizontal polarising filter so that the curve of reflection coefficient versus collected coolant depth becomes steeper, as the reflection and transmission coefficients depend on the state of polarisation of the light. Fresnel's equations define the reflection and transmission coefficients as a function of the angle of incidence $\theta$ and the refractive indices $n_1$ and $n_2$:

$$R_s = \left| \frac{n_1 \cos \theta_i - n_2 \cos \theta_t}{n_1 \cos \theta_i + n_2 \cos \theta_t} \right|^2 = \left| \frac{n_1 \cos \theta_i - n_2 \sqrt{1 - \left(\frac{n_1}{n_2} \sin \theta_i\right)^2}}{n_1 \cos \theta_i + n_2 \sqrt{1 - \left(\frac{n_1}{n_2} \sin \theta_i\right)^2}} \right|^2$$

$$R_p = \left| \frac{n_1 \cos \theta_t - n_2 \cos \theta_i}{n_1 \cos \theta_t + n_2 \cos \theta_i} \right|^2 = \left| \frac{n_1 \sqrt{1 - \left(\frac{n_1}{n_2} \sin \theta_i\right)^2} - n_2 \cos \theta_i}{n_1 \sqrt{1 - \left(\frac{n_1}{n_2} \sin \theta_i\right)^2} + n_2 \cos \theta_i} \right|^2$$

For moderate angles of incidence, there is a considerable difference in reflection coefficient between the s-polarised and p-polarised directions. Thus, polarised light can be used to provide greater selectivity as a function of collected coolant level.

As an alternative to an LED, the optical transmitter 62 may include a semiconductor laser which would result in a tightly collimated optical beam permitting a more precise predefined level of the collected coolant 58.

The mechanism, for detecting the leakage of coolant from the coolant circuits 38,40, further includes an outlet for permitting discharge 76 of the collected coolant 58 from the collector 60. The outlet is configured to have predetermined dimensions. Since the dimensions of the outlet are known, it becomes possible to correlate the coolant leakage flow rate with the collected coolant level in the collector 60. As shown in Figure 8, the outlet may be in the form of a weir 78 with a V-shaped groove on a side wall of the collector 60. The flow rate of coolant through the V-shaped groove is proportional to the height of the collected coolant 58 above it. Alternatively, the outlet may be in the form of a hole in the bottom of the collector.

It will be appreciated that each numerical value given for the embodiment shown is merely chosen to help illustrate the working of the invention, and may be replaced by another numerical value.

**Claims**

1. A thyristor valve assembly (30) comprising

   a corona shield (36) and a coolant carrier (38,40) for carrying coolant,
   the corona shield being connected to the thyristor valve assembly via a busbar (50), the coolant carrier (38,40) being arranged to interconnect a plurality of positions in the thyristor valve assembly and the thyristor valve assembly being operable so as to configure the plurality of positions to be at different electrical potentials, wherein the thyristor valve assembly further includes a power supply circuit (56) connected between a coolant carrier section and the corona shield such that, in use, the power supply circuit (56) is configured to draw a leakage current from the coolant carrier (38,40) so as to harvest the leakage current and to provide a power supply source for powering one or more electrical devices (100).

2. A thyristor valve assembly (30) according to Claim 1 including a plurality of electrical components, wherein each of the plurality of positions in the thyristor valve assembly corresponds to a respective one of the plurality of electrical components.

3. A thyristor valve assembly (30) according to Claim 2 wherein the thyristor valve assembly includes a plurality of additional electrical components, and the coolant carrier (38,40) is disconnected from the plurality of additional electrical components.

**4.** A thyristor valve assembly (30) according to anyone of the preceding claims wherein the thyristor valve assembly includes a switching valve.

**5.** A thyristor valve assembly (30) according to Claim 4 wherein the switching valve includes a plurality of switching modules (32), each of the plurality of positions corresponding to a respective one of the plurality of switching modules (32) such that the coolant carrier (38,40) is arranged to interconnect the plurality of switching modules (32).

**6.** A thyristor valve assembly (30) according to anyone of the preceding claims wherein the coolant carrier (38,40) is arranged to interconnect the plurality of positions such that, in use of the thyristor valve assembly, the coolant carrier (38,40) forms an electrically balanced circuit.

**7.** A thyristor valve assembly (30) according to Claim 6 further including an electrically conductive member, wherein the coolant carrier (38,40) is arranged to interconnect the plurality of positions and the electrically conductive member such that, in use of the thyristor valve assembly , the coolant carrier (38,40) forms an electrically balanced circuit.

**8.** A thyristor valve assembly (30) according to Claim 7 wherein the electrically conductive member is or includes the corona shield (36).

**9.** A thyristor valve assembly (30) according to Claim 8 wherein the corona shield (36) is arranged at one end of the thyristor valve assembly.

**10.** A thyristor valve assembly (30) according to Claim 9 in combination with Claim 5, wherein the corona shield (36) is arranged at one end of the plurality of switching modules (32).

**11.** A thyristor valve assembly (30) according to anyone of the preceding claims wherein the coolant carrier (38,40) includes first and second coolant carrier portions, each of the first and second coolant carrier portions arranged to interconnect the plurality of positions, the first and second coolant carrier portions being in fluid communication with each other.

**12.** A thyristor valve assembly (30) according to anyone of the preceding claims further including a collector (60) arranged to collect leaked or spilt coolant from the coolant carrier (38,40), and the thyristor valve assembly further includes a monitoring device configured to monitor a level of collected coolant (58) in the collector (60), wherein the collector (60) includes an outlet for permitting discharge (76) of the collected coolant (58) from the collector (60).

**13.** A thyristor valve assembly (30) according to Claim 12 wherein the monitoring device includes an optical source (62) configured to direct light (68) towards a surface of the collected coolant (58) in the collector (60), and the monitoring device further includes an optical sensor (64) configured to detect light (70) reflected off the surface of the collected coolant (58) in the collector (60).

**14.** A thyristor valve assembly (30) according to Claim 12 or Claim 13 wherein the outlet is in the form of a weir (78), or the outlet is in the form of a hole in a base of the collector.


**Patentansprüche**

**1.** Thyristorventilbaugruppe (30) umfassend

eine Koronaabschirmung (36) und einen Kühlmittelträger (38, 40) zum Transportieren von Kühlmittel,
wobei die Koronaabschirmung über eine Sammelschiene (50) mit der Thyristorventilbaugruppe verbunden ist,
wobei der Kühlmittelträger (38, 40) so angeordnet ist, dass er eine Vielzahl von Positionen in der Thyristorventilbaugruppe miteinander verbindet, und die Thyristorventilbaugruppe so betreibbar ist, dass sie die Vielzahl von Positionen so konfiguriert, dass sie auf unterschiedlichen elektrischen Potenzialen liegen,
wobei die Thyristorventilbaugruppe weiter eine Stromversorgungsschaltung (56) einschließt, die zwischen einem Kühlmittelträgerabschnitt und der Koronaabschirmung angeschlossen ist, so dass die Stromversorgungsschaltung (56) im Gebrauch so konfiguriert ist, dass sie einen Leckstrom aus dem Kühlmittelträger (38,40) zieht, um den Leckstrom zu ernten und eine Stromversorgungsquelle zur Versorgung einer oder mehrerer elektrischer Vorrichtungen (100) bereitzustellen.

2. Thyristorventilbaugruppe (30) nach Anspruch 1 mit einer Vielzahl von elektrischen Bauteilen, wobei jede der Vielzahl von Positionen in der Thyristorventilbaugruppe einem entsprechenden der Vielzahl von elektrischen Bauteilen entspricht.

3. Thyristorventilbaugruppe (30) nach Anspruch 2, wobei die Thyristorventilbaugruppe eine Vielzahl zusätzlicher elektrischer Bauteile einschließt und der Kühlmittelträger (38, 40) von der Vielzahl zusätzlicher elektrischer Bauteile getrennt ist.

4. Thyristorventilbaugruppe (30) nach einem der vorstehenden Ansprüche, wobei die Thyristorventilbaugruppe ein Schaltventil einschließt.

5. Thyristorventilbaugruppe (30) nach Anspruch 4, wobei das Schaltventil eine Vielzahl von Schaltmodulen (32) einschließt, wobei jede der Vielzahl von Positionen einem jeweiligen der Vielzahl von Schaltmodulen (32) entspricht, so dass der Kühlmittelträger (38,40) so angeordnet ist, dass er die Vielzahl von Schaltmodulen (32) miteinander verbindet.

6. Thyristorventilbaugruppe (30) nach einem der vorstehenden Ansprüche, wobei der Kühlmittelträger (38,40) so angeordnet ist, dass er die Vielzahl von Positionen miteinander verbindet, so dass der Kühlmittelträger (38,40) bei Verwendung der Thyristorventilbaugruppe einen elektrisch symmetrischen Stromkreis bildet.

7. Thyristorventilbaugruppe (30) nach Anspruch 6, weiter einschließend ein elektrisch leitfähiges Element, wobei der Kühlmittelträger (38, 40) so angeordnet ist, dass er die Vielzahl von Positionen und das elektrisch leitfähige Element miteinander verbindet, so dass der Kühlmittelträger (38, 40) bei Verwendung der Thyristorventilbaugruppe einen elektrisch symmetrischen Stromkreis bildet.

8. Thyristorventilbaugruppe (30) nach Anspruch 7, wobei das elektrisch leitfähige Element die Koronaabschirmung (36) ist oder einschließt.

9. Thyristorventilbaugruppe (30) nach Anspruch 8, wobei die Koronaabschirmung (36) an einem Ende der Thyristorventilbaugruppe angeordnet ist.

10. Thyristorventilbaugruppe (30) nach Anspruch 9 in Verbindung mit Anspruch 5, wobei die Koronaabschirmung (36) an einem Ende der Vielzahl von Schaltmodulen (32) angeordnet ist.

11. Thyristorventilbaugruppe (30) nach einem der vorstehenden Ansprüche, wobei der Kühlmittelträger (38, 40) einen ersten und einen zweiten Kühlmittelträgerabschnitt einschließt, wobei der erste und der zweite Kühlmittelträgerabschnitt jeweils so angeordnet sind, dass sie die Vielzahl von Positionen miteinander verbinden, wobei der erste und der zweite Kühlmittelträgerabschnitt in Fluidverbindung miteinander stehen.

12. Thyristorventilbaugruppe (30) nach einem der vorstehenden Ansprüche, weiter einschließend einen Sammler (60), der so angeordnet ist, dass er ausgelaufenes oder verschüttetes Kühlmittel aus dem Kühlmittelträger (38, 40) auffängt, und wobei die Thyristorventilbaugruppe weiter eine Überwachungsvorrichtung einschließt, die so konfiguriert ist, dass sie einen Pegel des aufgefangenen Kühlmittels (58) in dem Sammler (60) überwacht, wobei der Sammler (60) einen Auslass einschließt, der ein Ablassen (76) des aufgefangenen Kühlmittels (58) aus dem Sammler (60) ermöglicht.

13. Thyristorventilbaugruppe (30) nach Anspruch 12, wobei die Überwachungsvorrichtung eine optische Quelle (62) einschließt, die so konfiguriert ist, dass sie Licht (68) auf eine Oberfläche des gesammelten Kühlmittels (58) im Sammler (60) richtet, und wobei die Überwachungsvorrichtung weiter einen optischen Sensor (64) einschließt, der so konfiguriert ist, dass er Licht (70) erfasst, das von der Oberfläche des gesammelten Kühlmittels (58) im Sammler (60) reflektiert wird.

14. Thyristorventilbaugruppe (30) nach Anspruch 12 oder Anspruch 13, wobei der Auslass die Form eines Wehrs (78) hat oder der Auslass die Form eines Lochs in einem Boden des Sammlers hat.

**Revendications**

1. Ensemble soupape à thyristors (30) comprenant

   un écran anti-effluves (36) et un porteur de liquide de refroidissement (38, 40) pour porter un liquide de refroidissement,
   l'écran anti-effluves étant relié à l'ensemble soupape à thyristors via une barre omnibus (50), le porteur de liquide de refroidissement (38, 40) étant agencé pour interconnecter une pluralité de positions dans l'ensemble soupape à thyristors et l'ensemble soupape à thyristors étant utilisable de manière à configurer la pluralité de positions pour qu'elles soient à des potentiels électriques différents,
   dans lequel l'ensemble soupape à thyristors comprend en outre un circuit d'alimentation électrique (56) relié entre une section de porteur de liquide de refroidissement et l'écran anti-effluves de sorte que, en utilisation, le circuit d'alimentation électrique (56) tire soit configuré pour tirer un courant de fuite depuis le porteur de liquide de refroidissement (38,40) afin de récupérer le courant de fuite et de fournir une source d'alimentation électrique pour alimenter un ou plusieurs dispositifs électriques (100).

2. Ensemble soupape à thyristors (30) selon la revendication 1, comprenant une pluralité de composants électriques, dans lequel chacune de la pluralité de positions dans l'ensemble soupape à thyristors correspond à l'un respectif de la pluralité de composants électriques.

3. Ensemble soupape à thyristors (30) selon la revendication 2, dans lequel l'ensemble soupape à thyristors comprend une pluralité de composants électriques supplémentaires, et le porteur de liquide de refroidissement (38,40) est déconnecté de la pluralité de composants électriques supplémentaires.

4. Ensemble soupape à thyristors (30) selon l'une quelconque des revendications précédentes, dans lequel l'ensemble soupape à thyristors comprend une soupape de commutation.

5. Ensemble soupape à thyristors (30) selon la revendication 4, dans lequel la soupape de commutation comprend une pluralité de modules de commutation (32), chacune de la pluralité de positions correspondant à l'un respectif de la pluralité de modules de commutation (32) de sorte que le porteur de liquide de refroidissement (38,40) soit agencé pour interconnecter la pluralité de modules de commutation (32).

6. Ensemble soupape à thyristors (30) selon l'une quelconque des revendications précédentes, dans lequel le porteur de liquide de refroidissement (38,40) est agencé pour interconnecter la pluralité de positions de sorte que, en utilisation de l'ensemble soupape à thyristors, le porteur de liquide de refroidissement (38,40) constitue un circuit électriquement équilibré.

7. Ensemble soupape à thyristors (30) selon la revendication 6, comprenant en outre un élément électriquement conducteur, dans lequel le porteur de liquide de refroidissement (38,40) est agencé pour interconnecter la pluralité de positions et l'élément électriquement conducteur de sorte que, en utilisation de l'ensemble soupape à thyristors, le porteur de liquide de refroidissement (38,40) constitue un circuit électriquement équilibré.

8. Ensemble soupape à thyristors (30) selon la revendication 7, dans lequel l'élément électriquement conducteur est ou comprend l'écran anti-effluves (36).

9. Ensemble soupape à thyristors (30) selon la revendication 8, dans lequel l'écran anti-effluves (36) est agencé à une extrémité de l'ensemble soupape à thyristors.

10. Ensemble soupape à thyristors (30) selon la revendication 9 en combinaison avec la revendication 5, dans lequel l'écran anti-effluves (36) est agencé à une extrémité de la pluralité de modules de commutation (32).

11. Ensemble soupape à thyristors (30) selon l'une quelconque des revendications précédentes, dans lequel le porteur de liquide de refroidissement (38,40) comprend des première et seconde portions de porteur de liquide de refroidissement, chacune des première et seconde portions de porteur de liquide de refroidissement étant agencée pour interconnecter la pluralité de positions, les première et seconde portions de porteur de liquide de refroidissement étant en communication fluidique l'une avec l'autre.

12. Ensemble soupape à thyristors (30) selon l'une quelconque des revendications précédentes, comprenant en outre un collecteur (60) agencé pour collecter une fuite ou un déversement de liquide de refroidissement depuis le porteur de liquide de refroidissement (38,40), et l'ensemble soupape à thyristors comprend en outre un dispositif de surveillance configuré pour surveiller un niveau de liquide de refroidissement (58) collecté dans le collecteur (60), dans lequel le collecteur (60) comprend une sortie pour permettre une décharge (76) du liquide de refroidissement (58) collecté depuis le collecteur (60).

13. Ensemble soupape à thyristors (30) selon la revendication 12, dans lequel le dispositif de surveillance comprend une source optique (62) configurée pour diriger une lumière (68) vers une surface du liquide de refroidissement (58) collecté dans le collecteur (60), et le dispositif de surveillance comprend en outre un capteur optique (64) configuré pour détecter une lumière (70) réfléchie depuis la surface du liquide de refroidissement (58) collecté dans le collecteur (60).

14. Ensemble soupape à thyristors (30) selon la revendication 12 ou 13, dans lequel la sortie se présente sous la forme d'un déversoir (78), ou la sortie se présente sous la forme d'un trou dans une base du collecteur.

**Figure 1**

**Figure 2**

Figure 3

Figure 4

14

**Figure 5**

**Figure 6**

Figure 7

Figure 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S5788751 B
- GB 2544820 A
- US 2010020452 A